# EUROPÄISCHE PATENTANMELDUNG

(11) **EP 2 317 576 A2**
(43) Veröffentlichungstag der Anmeldung: **04.05.2011**
(21) Anmeldenummer: 10186544.2
(22) Anmeldetag: 05.10.2010
(51) Int. Cl.: H01L 35/08, H01L 35/34

(54) **Verfahren zum Herstellen eines Seebeckschenkelmoduls**

(30) Priorität: 28.10.2009 DE 102009046102
(71) Anmelder: Robert Bosch GmbH, 70442 Stuttgart (DE)
(72) Erfinder: Offterdinger, Joerg, 70437, Stuttgart (DE); Voigtlaender, Klaus, 73117, Wangen (DE); Danner, Reinhold, 72108, Rottenburg (DE); Zywietz, Martin, 71642, Ludwigsburg (DE); Schweiker, Markus-Alexander, 77830, Buehlertal (DE); Scheuerer, Roland, 70565, Stuttgart (DE); Goebel, Ulrich, 72760, Reutlingen (DE); Schmidt, Lothar, 72800, Eningen (DE)

(57) **Zusammenfassung**

Die Erfindung betrifft ein Verfahren zum Herstellen eines Seebeckschenkelmoduls (1) mit einer vorgegebenen Anzahl von zwischen zwei Keramikträgern (16) angeordneten Seebeckschenkeln (10), wobei die Keramikträger (16) zumindest an ihren den Seebeckschenkeln (10) zugewandten Seiten aus einem elektrisch isolierenden Material bestehen und an diesen Seiten mit von metallischen Verbindern (12) gebildeten Kontaktflächen versehen werden, die über eine Kontaktierschicht (14) mit dem jeweiligen Seebeckschenkel (10) verbunden werden. Erfindungsgemäß wird ein erster Keramikträger (16) mit metallischen Verbindern (12) in eine Werkstückaufnahme eingelegt und mit der vorgegebenen Anzahl von Seebeckschenkeln (10) des Seebeckschenkelmoduls (1) bestückt, auf welche ein zweiter Keramikträger (16) mit metallischen Verbindern (12) aufgesetzt wird, wobei zwischen den einzelnen Seebeckschenkeln (10) und den jeweiligen Kontaktflächen der metallischen Verbinder (12) des ersten und zweiten Keramikträgers (16) Material zur Ausbildung der Kontaktierschichten (14) eingebracht wird, wobei die mit den Keramikträgern (16) und der vorgegebenen Anzahl von Seebeckschenkeln (10) des Seebeckschenkelmoduls (1) bestückte Werkstückaufnahme in eine entsprechende Vorrichtung eingeführt wird, in welcher alle Kontaktschichten (14) des Seebeckschenkelmoduls (1) in einem einzigen Fertigungsprozess fertig gestellt werden.

## Beschreibung

### Stand der Technik

Die Erfindung geht aus von einem Verfahren zum Herstellen eines Seebeckschenkelmoduls nach der Gattung des unabhängigen Patentanspruchs 1. Ausführungsformen des mit dem erfindungsgemäßen Verfahren hergestellten Seebeckschenkelmoduls können in Abhängigkeit von der Arbeitstemperatur beispielsweise in einem thermoelektrischen Generator und/oder in einem Peltierelementmodul verwendet werden.

Derzeit werden in der Automobilindustrie Untersuchungen und Entwicklungen für einen thermoelektrischen Generator durchgeführt, um unter Ausnutzung des Seebeckeffekts aus einem heißen Abgasstrom Strom für das Fahrzeugbordnetz zu gewinnen und dadurch den Gesamtwirkungsgrad des Antriebs mit Verbrennungsmotor zu erhöhen. Zur Herstellung eines solchen thermoelektrischen Generators sind viele Thermoelementpaare elektrisch in Reihe zu verbinden, thermisch anzukoppeln und mechanisch zu befestigen. Die Einzelelemente jedes Thermoelements werden hier im Folgenden als "Seebeckschenkel" bezeichnet, wobei je Thermoelement zwei Schenkel mit unterschiedlich ausgeprägtem Seebeck-Effekt erforderlich sind. Ein Verbund mit einer vorgegebenen Anzahl von solchen Thermoelementpaaren wird als Seebeckschenkelmodul bezeichnet.

In der Offenlegungsschrift WO 2007/098736 A2 wird beispielsweise ein Verfahren zum Herstellen von Peltiermodulen mit jeweils mehreren zwischen zwei Substraten angeordneten Peltierelementen beschrieben. Hierbei bestehen die Substrate zumindest an ihren den Peltierelementen zugewandten Seiten aus einem elektrisch isolierenden Material und sind an diesen Oberflächenseiten mit von metallischen Bereichen gebildeten Kontaktflächen versehen, mit denen die Peltierelemente bei der Herstellung mit Anschlussflächen verbunden werden. Hierbei erfolgt die Herstellung der Peltiermodule in der Weise, dass ein in geeigneter Weise hergestellter Peltierwafer in einzelne Peltierelemente zerteilt wird und diese Elemente dann an den Kontaktflächen der Keramiksubstrate über eine der Verbindungen derart befestigt werden, dass über die betreffende Verbindung an jeder Kontaktfläche ein Peltierelement vorgesehen ist und zwar an sämtlichen Kontaktflächen jeweils eines Keramik-Substrats jeweils in der selben elektrischen Orientierung bzw. mit dem selben Pol. Jeweils zwei so mit Peltierelementen vorbestückte Keramik-Substrate werden dann entsprechend aufeinander gesetzt, so dass die Peltierelemente über die Kontaktflächen elektrisch in Serie liegen. Durch eine auf die freien Enden oder Anschlussseiten der Peltierelemente aufgebrachte Lotschicht werden die Peltierelemente an jedem Keramiksubstrat mit ihrer bis dahin freiliegenden, nicht kontaktierten Anschlussseiten mechanisch sowie elektrisch mit jeweils einer Kontaktfläche an dem jeweils anderen KeramikSubstrat verbunden. Bei dem beschriebenen Verfahren sind somit mindestens drei Lötverfahren erforderlich, um die Peltiermodule aus den Peltierelementen und den Keramik-Substraten herzustellen.

### Offenbarung der Erfindung

Das erfindungsgemäße Verfahren zum Herstellen eines Seebeckschenkelmoduls mit den Merkmalen des unabhängigen Patentanspruchs 1 hat demgegenüber den Vorteil, dass ein Seebeckschenkelmodul mit einer vorgegebenen Anzahl von zwischen zwei Keramikträgern angeordneten Seebeckschenkeln in einem einzigen Vorgang miteinander kontaktiert bzw. verbunden werden. Das bedeutet, dass die jeweiligen Seebeckschenkel jeweils über eine korrespondierende Kontaktschicht gleichzeitig mit Kontaktflächen von metallischen Verbindern eines ersten und eines zweiten Keramikträgers kontaktiert bzw. verbunden werden. Hierbei bestehen die Keramikträger zumindest an ihren den Seebeckschenkeln zugewandten Seiten aus einem elektrisch isolierenden Material auf welche die metallischen Verbinder angeordnet sind. Zur Herstellung der Verbindung wird der erste Keramikträger mit den metallischen Verbindern in eine Werkstückaufnahme eingelegt und mit der vorgegebenen Anzahl von Seebeckschenkeln bestückt, auf welche der zweiter Keramikträger mit den metallischen Verbindern aufgesetzt wird, wobei zwischen den einzelnen Seebeckschenkeln und dem ersten und zweiten Keramikträger Material zur Ausbildung der Kontaktierschichten eingebracht wird. Die mit den Keramikträgern und der vorgegebenen Anzahl von Seebeckschenkeln des Seebeckschenkelmoduls bestückte Werkstückaufnahme wird in eine entsprechende Vorrichtung eingeführt, in welcher alle Kontaktschichten des Seebeckschenkelmoduls in einem einzigen Fertigungsprozess fertig gestellt werden. Ausführungsformen eines durch das erfindungsgemäße Verfahren hergestellten Seebeckschenkelmoduls können in Abhängigkeit von der Arbeitstemperatur beispielsweise in einem thermoelektrischen Generator und/oder in einem Peltierelementmodul verwendet werden.

Durch Ausführungsformen der Erfindung werden metallisch an den Stirnseiten kontaktierbare Seebeckschenkel mit den als Brücken ausgeführten metallischen Verbindern niederohmig kontaktiert und dadurch elektrisch in Reihe geschaltet. Die verschiedenen metallischen Verbinder sind elektrisch gegeneinander und nach "oben" bzw. "unten" isoliert, wobei die elektrische Isolation thermisch gut leitend ausgeführt ist. Die metallischen Verbinder können beispielsweise über ein Standardverfahren der Dickschichttechnik, wie beispielsweise ein Siebdruckverfahren auf die Keramikträger aufgebracht werden. Das jeweilige Seebeckschenkelmodul wird in einem thermoelektrischen Generator auf der heißen Seite typischer Weise mit ca. 600°C und auf der kalten Seite mit ca. 100°C betrieben. Dabei ist die mögliche Betriebstemperatur der heißen Seite des thermoelektrischen Generators von den eingesetzten Materialen für die Seebeckschenkel abhängig.

Durch die in den abhängigen Ansprüchen aufgeführten Maßnahmen und Weiterbildungen sind vorteilhafte Verbesserungen des im unabhängigen Patentanspruch 1 angegebenen Verfahrens zum Herstellen eines Seebeckschenkelmoduls möglich.

In Ausgestaltung des erfindungsgemäßen Verfahrens können die Kontaktierschichten des Seebeckschenkelmoduls in der entsprechenden Vorrichtung beispielsweise durch Sintern hergestellt werden. Dadurch werden die Seebeckschenkel elektrisch, mechanisch und thermisch mit den Keramikträgern verbunden.

Alternativ können die Kontaktierschichten des Seebeckschenkelmoduls in der entsprechenden Vorrichtung durch Löten hergestellt werden. Der Lötvorgang kann beispielsweise in einem Durchlaufofen oder von einer Kontaktlötvorrichtung ausgeführt werden. Bei einem Kontaktlötvorgang können die Heizflächen maschinell auf den gewünschten Abstand gebracht werden, so dass die Dicke des Seebeckschenkelmoduls sehr gut definiert ist. In vorteilhafter Weise kann der Kontaktlötvorgang schnell ausgeführt werden, da die Wärmeübertragung durch einen Kontakt erfolgt und nicht durch Gas wie im Durchlaufofen.

In weiterer Ausgestaltung des erfindungsgemäßen Verfahrens werden die Oberflächen der metallischen Verbinder und/oder der Seebeckschenkel vor dem Einbringen in die Werkstückaufnahme veredelt, um die elektrischen und/oder thermischen Eigenschaften in vorteilhafter Weise zu verbessern.

In weiterer Ausgestaltung des erfindungsgemäßen Verfahrens können die Seebeckschenkel des Seebeckschenkelmoduls vorbestückt in einem entsprechenden Magazin bereitgestellt und gemeinsam in die Werkstückaufnahme eingelegt werden, um das Bestücken der Werkstückaufnahme mit allen Seebeckschenkeln des Seebeckschenkelmoduls zu beschleunigen. Alternativ kann das Bestücken der Seebeckschenkel sequenziell mit aus der SMD-Montage bekannten Standardbestückern erfolgen.

Besonders vorteilhaft ist, dass nach dem Einlegen des ersten Keramikträgers Justiermittel in die Werkstückaufnahme eingelegt werden, welche eine Matrix mit Öffnungen für die vorgegebene Anzahl von Seebeckschenkeln des Seebeckschenkelmoduls ausbilden. Durch die Justiermittel können die einzelnen Seebeckschenkel in vorteilhafter Weise gegen Umfallen gesichert werden. Die Justiermittel werden als Hilfswerkzeug nur für den Herstellprozess verwendet und hinterher aus dem Seebeckschenkelmodul entfernt. Die Justiermittel werden beispielsweise als kammartige Blechplatten ausgeführt, welche nach dem Herstellungsprozess einfach und schnell aus dem Seebeckschenkelmodul gezogen werden können. Um das Ein- und Ausfahren der Justiermittel zu erleichtern, werden die Zinken der Justiermittel etwas schmaler als der Sollabstand der Seebeckschenkel ausgebildet, wobei mindestens zwei Justiermittel mit einem Winkel von 90° zueinander und in z-Richtung übereinander angeordnet werden, und wobei die beiden kammartigen Justiermittel in x- und/oder y-Richtung mechanisch verschoben werden, um die Seebeckschenkel des Seebeckschenkelmoduls auszurichten.

In weiterer Ausgestaltung des erfindungsgemäßen Verfahrens werden die kammartigen Justiermittel jeweils aus zwei übereinander liegenden kammartigen Teilblechplatten gebildet, deren Zinken etwas schmaler als der Sollabstand der Seebeckschenkel ausgebildet werden, wobei die beiden kammartigen Teilplatten der jeweiligen Justiermittel gegeneinander verschiebbar ausgebildet werden. Im eingefahrenen Zustand werden die Teilplatten etwas gegeneinander verschoben, so dass die Position der Seebeckschenkel dadurch genauer eingegrenzt werden kann. Beim Ein- und Ausfahren der Justiermittel liegen beide Teilblechplatten genau übereinander, sodass die Zinken verschmälert sind und leicht bewegt werden können. Dadurch kann eine Klemmneigung der Justiermittel in vorteilhafter Weise reduziert werden.

Vorteilhafte Ausführungsformen der Erfindung sind in den Zeichnungen dargestellt und werden nachfolgend beschrieben. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Schnittdarstellung eines Ausschnitts eines Seebeckschenkelmodul, das gemäß einem erfindungsgemäßen Verfahren hergestellt wurde.
Figur 2 zeigt eine schematische Schnittdarstellung des in Fig. 1 dargestellten Ausschnitts des Seebeckschenkelmodul während des Herstellungsprozesses.
Figur 3 zeigt eine schematische Schnittdarstellung entlang der Schnittlinie III - III aus Fig. 2.
Figur 4 zeigt eine schematische Schnittdarstellung entlang der Schnittlinie IV - IV aus Fig. 2.

### Ausführungsformen der Erfindung

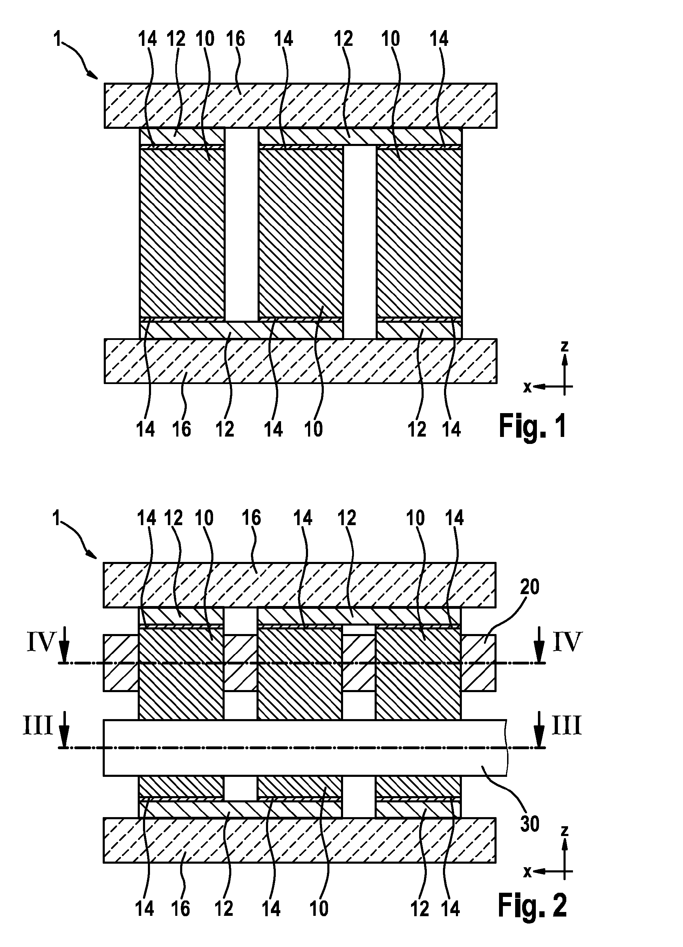

Wie aus Fig. 1 ersichtlich ist, umfasst ein Seebeckschenkelmodul 1, das in Abhängigkeit von der Arbeitstemperatur beispielsweise in einem thermoelektrischen Generator und/oder in einem Peltierelementmodul verwendet werden kann, eine vorgegebene Anzahl von zwischen zwei Keramikträgern 16 angeordneten Seebeckschenkeln 10, wobei die Keramikträger 16 zumindest an ihren den Seebeckschenkeln 10 zugewandten Seiten aus einem elektrisch isolierenden Material bestehen und an diesen Seiten mit von metallischen Verbindern 12 gebildeten Kontaktflächen versehen sind, die über eine Kontaktierschicht 14 mit dem jeweiligen Seebeckschenkel 10 verbunden sind. Die metallischen Verbinder 12 können beispielsweise durch ein DBC-Verfahren (DBC: Direct Bonded Copper) oder durch Standard-Dichtschichtverfahren mit Silber und Nickelplating oder mit Kupfer ausgebildet werden.

Erfindungsgemäß wird zur Herstellung des Seebeckschenkelmoduls 1 ein erster Keramikträger 16 mit den metallischen Verbindern 12 in eine Werkstückaufnahme eingelegt und mit der vorgegebenen Anzahl von Seebeckschenkeln 10 bestückt. Auf der vorgegebenen Anzahl von Seebeckschenkeln 10 wird ein zweiter Keramikträger 16 mit den metallischen Verbindern 12 aufgesetzt, wobei zwischen den einzelnen Seebeckschenkeln 10 und den jeweiligen Kontaktflächen der metallischen Verbinder 12 des ersten und zweiten Keramikträgers 16 Material zur Ausbildung der Kontaktierschichten 14 eingebracht wird. Anschließend wird die mit den Keramikträgern 16 und der vorgegebenen Anzahl von Seebeckschenkeln 10 des Seebeckschenkelmoduls 1 bestückte Werkstückaufnahme in eine entsprechende Vorrichtung eingeführt, in welcher alle Kontaktschichten 14 des Seebeckschenkelmoduls 1 in einem einzigen entsprechenden Fertigungsprozess fertig gestellt werden. So können die Kontaktierschichten 14 des Seebeckschenkelmoduls 1 beispielsweise durch Sintern und/oder durch Löten hergestellt werden. Der Sinterprozess und/oder Lötprozess können in einem Durchlaufofen durchgeführt werden. Alternativ kann der Lötprozess von einer Kontaktlötvorrichtung ausgeführt werden. Beim "Kontaktlötvorgang" können die Heizflächen maschinell auf den gewünschten Abstand gebracht werden, so dass die Dicke des Moduls sehr gut definiert ist. Zudem kann der Lötprozess schnell ausgeführt werden, da die Wärmeübertragung durch einen Kontakt erfolgt und nicht durch Gas wie beim Durchlaufofen.

Je nach dem nachfolgenden Verbindungsprozess können Sintermaterialien oder Lötmaterialien zur Ausbildung der Kontaktschichten 14 zwischen den Seebeckschenkeln 10 und den metallischen Verbindern 12 angeordnet werden. Des Weiteren können die Oberflächen der metallischen Verbinder 12 und/oder der Seebeckschenkel 10 vor dem Einbringen in die Werkstückaufnahme veredelt werden, um die elektrischen und/oder thermischen Eigenschaften der Kontaktierung bzw. Verbindung zu verbessern. Das Bestücken der nicht dargestellten Werkstückaufnahme mit der vorgegebenen Anzahl von Seebeckschenkeln 10 des Seebeckschenkelmoduls 1 kann mit Standardbestückern, welche in bekannter Weise für die SMD-Montage eingesetzt werden, beispielsweise sequenziell erfolgen. Zur Beschleunigung dieses Arbeitsschritts kann die vorgegebene Anzahl von Seebeckschenkeln 10 des Seebeckschenkelmoduls 1 auch vorbestückt in einem entsprechenden Magazin bereitgestellt und dann gleichzeitig bestückt werden.

Wenn die Seebeckschenkel 10 deutlich dicker sind als breit und lang, besteht die Gefahr des Umfallens. Dies kann durch in Fig. 2 bis 4 dargestellte erste und/oder zweite Justiermittel 20, 30 verhindert werden.

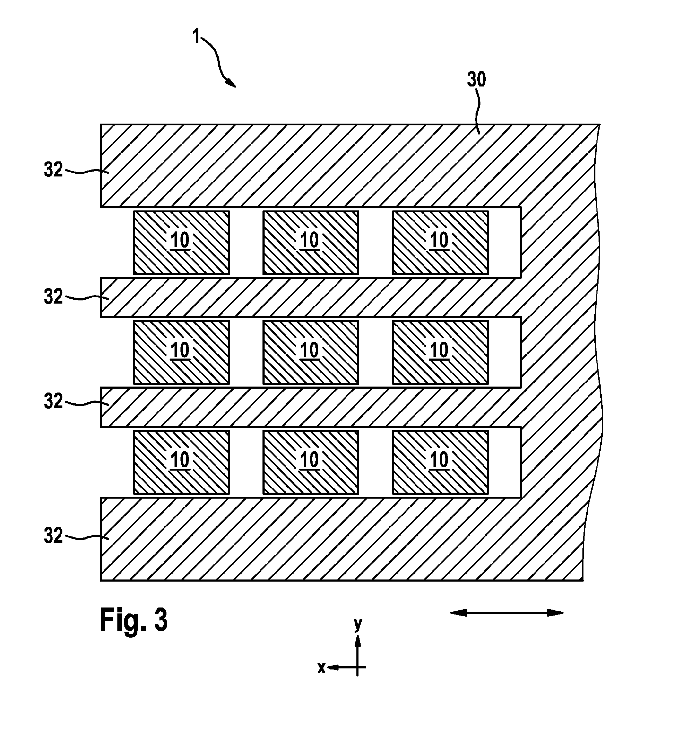

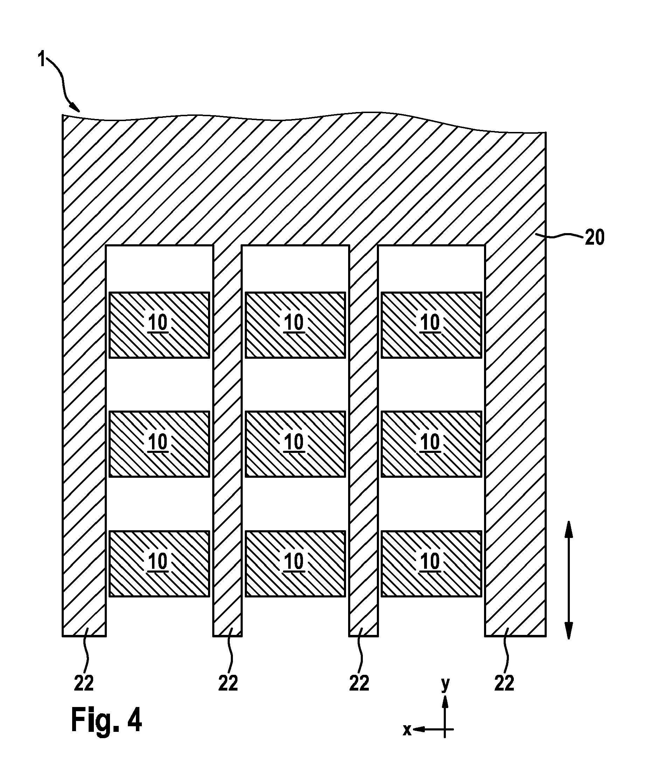

Wie aus Fig. 2 bis 4 ersichtlich ist, bilden die in die Werkstückaufnahme eingelegten Justiermittel 20, 30 eine Matrix mit Öffnungen für die vorgegebene Anzahl von Seebeckschenkeln 10 des Seebeckschenkelmoduls 1 aus. Wie aus Fig. 3 und 4 ersichtlich ist, sind die Justiermittel 20, 30 als kammartige Blechplatten ausgeführt, welche nach dem Herstellungsprozess aus dem Seebeckschenkelmodul 1 gezogen werden. Hierbei sind Zinken 22, 32 der Justiermittel 20, 30 etwas schmaler als der Sollabstand der Seebeckschenkel 10 ausgebildet, wobei im dargestellten Ausführungsbeispiel zwei als kammartige Blechplatten ausgeführte Justiermittel 20, 30 mit einem Winkel von 90° zueinander und in z-Richtung übereinander angeordnet sind. Die beiden kammartigen Justiermittel 20, 30 können in x- und/oder y-Richtung mechanisch verschoben werden, um die Seebeckschenkel 10 entsprechend auszurichten.

Erfindungsgemäß findet der einzige Fertigungsprozess der Kontaktschichten 14 des Seebeckschenkelmoduls 1 in einer einzigen Vorrichtung statt. Hierbei wird bei der Verwendung einer Lötvorrichtung der untere Keramikträger 16 mit Lotpaste bedruckt und in die Werkstückaufnahme eingelegt. Anschließend werden die als kammartige Blechplatten ausgeführten Justiermittel 20, 30 zusammen geschoben, so dass die Matrix mit Öffnungen für die Seebeckschenkel 10 entsteht und sich richtig justiert über dem unteren Keramikträger 16 befindet. Anschlieβend wird die vorgegebene Anzahl von Seebeckschenkel 10 des Seebeckschenkelmoduls 1 in die Öffnungen eingesetzt, wobei das Bestücken der Seebeckschenkel 10 sequenziell mit aus der SMD-Montage bekannten Standardbestückern erfolgen kann. Wie oben bereits ausgeführt ist, kann die vorgegebene Anzahl von Seebeckschenkeln des Seebeckschenkelmoduls zur Beschleunigung dieses Arbeitsschritts auch vorbestückt in einem entsprechenden Magazin bereitgestellt und gleichzeitig bestückt werden. Anschließend wird der obere Keramikträger 16 mit Lotpaste bedruckt und über Kopf gedreht auf die Seebeckschenkel 10 aufgesetzt. Dann werden von oben und unten beheizte metallische Stempel mit den Keramikträgern 16 in Kontakt gebracht und dadurch die einzelnen Komponenten in einem einzigen Fertigungsprozess miteinander verlötet, wobei der Sollabstand über ein Anschlagssystem sichergestellt werden kann. Die Dauer des Lötprozesses mit Aufheizen und Abkühlen ist wegen des Kontaktlötvorgangs gering. Dann werden die als kammartige Blechplatten ausgeführten Justierelemente 20, 30 aus dem Seebeckschenkelmodul 1 herausgezogen, wobei die Bewegungsrichtungen der Justiermittel 20, 30 in Fig. 3 und 4 jeweils durch einen Doppelpfeil angezeigt werden. Sollte das System beim Herausziehen der Justiermittel 20, 30 zum Klemmen neigen, können die kammartigen Justiermittel 20, 30 jeweils aus zwei übereinander liegenden kammartigen Teilblechplatten gebildet werden, deren Zinken 22, 32 etwas schmaler als der Sollabstand der Seebeckschenkel 10 ausgebildet werden, wobei die beiden kammartigen Teilplatten der jeweiligen Justiermittel 20, 30 gegeneinander verschiebbar ausgebildet werden. Im eingefahrenen Zustand werden die Teilplatten etwas gegeneinander verschoben, so dass die Position der Seebeckschenkel 10 dadurch genauer eingegrenzt ist. Beim Ein- und Ausfahren der Justiermittel 20, 30 werden die beiden Teilplatten so verschoben, dass sie genau übereinander liegen und die Zinken verschmälert sind und leicht bewegt werden können. Abschließend kann das Seebeckschenkelmodul 1 zur Weiterverarbeitung entnommen werden.

Ausführungsformen der Erfindung ermöglichen in vorteilhafter Weise eine schnellere Fertigung von Seebeckschenkelmodulen mit der vorgegebenen Anzahl von Seebeckschenkeln, da zur Kontaktierung bzw. Verbindung der vorgegebenen Anzahl von zwischen zwei Keramikträgern angeordneten Seebeckschenkeln nur ein Verbindungsvorgang bzw. Kontaktiervorgang erforderlich ist. Zudem können Ausführungsformen des mit dem erfindungsgemäßen Verfahren hergestellten Seebeckschenkelmoduls in Abhängigkeit von der Arbeitstemperatur beispielsweise in einem thermoelektrischen Generator und/oder in einem Peltierelementmodul verwendet werden.

## Patentansprüche

1. Verfahren zum Herstellen eines Seebeckschenkelmoduls mit einer vorgegebenen Anzahl von zwischen zwei Keramikträgern (16) angeordneten Seebeckschenkeln (10), wobei die Keramikträger (16) zumindest an ihren den Seebeckschenkeln (10) zugewandten Seiten aus einem elektrisch isolierenden Material bestehen und an diesen Seiten mit von metallischen Verbindern (12) gebildeten Kontaktflächen versehen werden, die über eine Kontaktierschicht (14) mit dem jeweiligen Seebeckschenkel (10) verbunden werden, **dadurch gekennzeichnet, dass** ein erster Keramikträger (16) mit metallischen Verbindern (12) in eine Werkstückaufnahme eingelegt und mit der vorgegebenen Anzahl von Seebeckschenkeln (10) des Seebeckschenkelmoduls (1) bestückt wird, auf welche ein zweiter Keramikträger (16) mit metallischen Verbindern (12) aufgesetzt wird, wobei zwischen den einzelnen Seebeckschenkeln (10) und den jeweiligen Kontaktflächen der metallischen Verbinder (12) des ersten und zweiten Keramikträgers (16) Material zur Ausbildung der Kontaktierschichten (14) eingebracht wird, wobei die mit den Keramikträgern (16) und der vorgegebenen Anzahl von Seebeckschenkeln (10) des Seebeckschenkelmoduls (1) bestückte Werkstückaufnahme in eine entsprechende Vorrichtung eingeführt wird, in welcher alle Kontaktschichten (14) des Seebeckschenkelmoduls (1) in einem einzigen Fertigungsprozess fertig gestellt werden.

2. Verfahren nach Anspruch 1, **dadurch gekennzeichnet, dass** die Kontaktierschichten (14) in der entsprechenden Vorrichtung durch Sintern gefertigt werden.

3. Verfahren nach Anspruch 1 oder 2, **dadurch gekennzeichnet, dass** die Kontaktierschichten (14) in der entsprechenden Vorrichtung durch Löten gefertigt werden.

4. Verfahren nach Anspruch 3, **dadurch gekennzeichnet, dass** der Lötvorgang in einem Durchlaufofen oder von einer Kontaktlötvorrichtung ausgeführt wird.

5. Verfahren nach einem der Ansprüche 1 bis 4, **dadurch gekennzeichnet, dass** die Oberflächen der metallischen Verbinder (12) und/oder der Seebeckschenkel (10) vor dem Einbringen in die Werkstückaufnahme veredelt werden.

6. Verfahren nach einem der Ansprüche 1 bis 5, **dadurch gekennzeichnet, dass** die vorgegebene Anzahl von Seebeckschenkeln (10) des Seebeckschenkelmoduls (1) vorbestückt in einem entsprechenden Magazin bereitgestellt und gemeinsam in die Werkstückaufnahme eingelegt wird.

7. Verfahren nach einem der Ansprüche 1 bis 6, **dadurch gekennzeichnet, dass** nach dem Einlegen des ersten Keramikträgers (16) Justiermittel (20, 30) in die Werkstückaufnahme eingefahren werden, welche eine Matrix mit Öffnungen für die vorgegebene Anzahl von Seebeckschenkeln (10) des Seebeckschenkelmoduls (1) ausbilden.

8. Verfahren nach Anspruch 7, **dadurch gekennzeichnet, dass** die Justiermittel (20, 30) als kammartige Blechplatten ausgeführt werden, welche nach dem Herstellungsprozess aus dem Seebeckschenkelmodul (1) gezogen werden.

9. Verfahren nach Anspruch 7 oder 8, **dadurch gekennzeichnet, dass** Zinken (22, 32) der Justiermittel (20, 30) etwas schmaler als der Sollabstand der Seebeckschenkel (10) ausgebildet werden, wobei mindestens zwei Justiermittel (20, 30) mit einem Winkel von 90° zueinander und in z-Richtung übereinander angeordnet werden, wobei die beiden kammartigen Justiermittel (20, 30) in x- und/oder y-Richtung mechanisch verschoben werden, um die vorgegebene Anzahl von Seebeckschenkeln (10) auszurichten.

10. Verfahren nach einem der Ansprüche 7 bis 9, **dadurch gekennzeichnet, dass** die kammartigen Justiermittel (20, 30) jeweils aus zwei übereinander liegenden kammartigen Teilblechplatten gebildet werden, deren Zinken (22, 32) etwas schmaler als der Sollabstand der Seebeckschenkel (10) ausgebildet werden, wobei die beiden kammartigen Teilplatten der jeweiligen Justiermittel (20, 30) gegeneinander verschiebbar ausgebildet werden.
